Europäisches Patentamt

European Patent Office

Office européen des brevets

(19)

(11) **EP 0 702 096 A1**

(12) **EUROPÄISCHE PATENTANMELDUNG**

(43) Veröffentlichungstag:
    **20.03.1996  Patentblatt 1996/12**

(51) Int. Cl.⁶: **C22C 45/04**, H01F 1/153,
    H01L 41/20, G08B 13/24

(21) Anmeldenummer: 95110876.0

(22) Anmeldetag: **12.07.1995**

(84) Benannte Vertragsstaaten:
    **BE DE FR GB**

(30) Priorität: **02.08.1994 DE 9412456 U**

(71) Anmelder: **VACUUMSCHMELZE GMBH**
    **D-63450 Hanau (DE)**

(72) Erfinder: **Herzer, Giselher, Dr.**
    **D-63486 Bruchköbel (DE)**

(54) **Verwendung einer amorphen Legierung auf FeCo-Basis für auf mechanischer Resonanz basierenden Überwachungssystemen**

(57)    Amorphe magnetostriktive Legierungen nach der Formel

$$(Fe_{1-a-b}Co_aNi_b)_{100-x-y-z}M_xSi_yB_z$$

wobei a bis z folgenden Bedingungen genügen: a liegt zwischen 0.25 bis 0.9 b liegt zwischen 0 bis 5 x liegt zwischen 0 bis 5, y liegt zwischen 0 bis 12, z liegt zwischen 11 bis 20 mit der Maßgabe, daß die Summe $x + y > 0,5$, die Summe $a + b$ zwischen 0,25 bis 0,9 und die Summe $x + y + z$ zwischen 12 und 28 liegt. Diese Legierungen weisen gleichzeitig eine hohe induzierte magnetische Anisotropie auf und sind für Identifizierungssysteme mit mechanisch schwingenden Legierungsstreifen dadurch besonders geeignet.

EP 0 702 096 A1

Printed by Rank Xerox (UK) Business Services
2.9.13/3.4

**Beschreibung**

Die Erfindung betrifft die Verwendung einer amorphen magnetoztriktiven Legierung für Überwachungssysteme mit magnetoelastisch anregbaren Etiketten.

Aus WO 90/03652 ist es bekannt, amorphe Legierungen für Überwachungssysteme mit mechanischer Resonanz zu verwenden, die neben Eisen im wesentlichen Nickel enthalten.

Legierungen mit magnetostriktiven Eigenschaften lassen sich beispielsweise bei Identifizierungssystemen für Etiketten verwenden. Hier wird die Magnetostriktion ausgenutzt, um durch ein auf einen Streifen dieser Legierung einwirkendes Wechselfeld diesen Streifen in Schwingungen zu versetzen. Wenn das Wechselfeld abgeschaltet wird, erzeugt der weiterschwingende Streifen magnetische Feldänderungen, die von einer Aufnehmerspule in induzierte Spannungsimpulse umgesetzt werden. Eine Auswertung dieser Spannungsimpulse läßt erkennen, ob ein Streifen dieses schwingenden Materials mit bestimmter Streifenlänge in dem Feld enthalten ist oder nicht.

Hiermit können sowohl Waren identifiziert werden durch Aufbringen mehrerer Streifen oder mehrerer durch Dauermagnete beeinflußter Streifen oder es kann auch auf diesem Prinzip ein Diebstahlsicherungssystem basieren, bei dem nur aufmagnetisierte Streifen bestimmter Länge mit den Waren verbunden sind und die Anwesenheit eines solchen Streifens durch das Spulensystem zur Felderregung und zur Aufnahme der magnetischen Schwingungen nach jedem Erregungszeitraum festgestellt wird.

Aufgabe der Erfindung ist es, Legierungen anzugeben, die speziell für die Zwecke der Anwendung als Identifizierungsstreifen weiter verbesserte magnetoelastische Eigenschaften aufweisen. Dies wird dadurch erreicht, daS eine Fe und Co enthaltende amorphe Legierung verwendet wird. Hierdurch kann sowohl ein hohes Signal als auch eine lange Abklingzeit erzielt werden. Erfindungsgemäß wurde erkannt, daß durch die Auswahl von magnetostriktiven Legierungen, die gleichzeitig hohe Werte für die induzierte magnetische Anisotropie aufweisen, eine Kombination von hohem Signal und langer Abklingzeit verwirklicht werden kann.

Gelöst wird diese Aufgabe dadurch, daS eine Legierung verwendet wird, die der im Kennzeichen des Patentanspruchs 1 angegebenen Formel genügt.

Vorteilhafte Weiterbildungen der Erfindung sind in den Unteransprüchen beschrieben.

Bei der erfindungsgemäßen Anwendung der beanspruchten Legierungen zur Kennzeichnung von Waren und/oder als Diebstahlsicherung bedingt die Magnetostriktion, daß der Streifen leicht ins Schwingen gerät. Es wurde gefunden, daß die erfindungsgemäßen Legierungen durch Wärmebehandlung mit einer hohen induzierten Anisotropie hergestellt werden können. In der Praxis lassen sich mit diesen Legierungen Abklingzeiten von größer 0,5 bis 20 msec erreichen. Als Abklingzeit wird dabei die Zeit nach einer Erregung verstanden, in der der Ausgangspegel der induzierten Spannung auf ein Zehntel seines Ausgangswertes abgefallen ist. Dieser Zeitraum reicht aus, um einerseits ein sicheres Erkennen des Nachschwingens eines solchen Streifens zu ermöglichen und um andererseits genügend Abfragen pro Sekunde mit kurzen Impulsen durchführen zu können.

An verschiedenen, in der nachstehenden Tabelle aufgeführten Legierungen wurde die Abklingzeit $t_R$ in msec und die Signalamplitude $U_2$ in mV bei verschiedenen Vormagnetisierungsfeldern H in A/m gemessen. Hierzu wurden Proben mit einer Länge von 40 mm, einer Breite von 12,5 mm und einer Dicke von etwa 25 µm aus den angegebenen Legierungszusammensetzungen ausgewählt. Die Legierungen wurden durch Abschrecken zu einem amorphen Band gegossen und anschließend in einem Magnetfeld quer zur Bandlängsrichtung wärmebehandelt. Die Wärmebehandlung fand bei einer Temperatur zwischen 200 und 450°C für eine Zeit von 10 min bis 5 h statt. Hierdurch erhalten die Bänder eine Anisotropie quer zur Bandrichtung.

Die so hergestellten Proben wurden in einem Gleichfeld der Stärke $H_{DC}$ angeordnet und dann mit Wechselfeldspulen einem Hochfrequenzfeld für eine Dauer von 2,5 msec und einer Stärke von 1,4 A/m ausgesetzt. Die Frequenz des Wechselfeldes wurde zwischen 50 kHz und 65 kHz so gewählt, daß sich ein Maximum der Signalamplitude als Funktion der Frequenz ergab.

In der nachstehenden Tabelle 1 bedeutet $t_R$ die Abklingzeit in msec. $t_R$ ist dabei die Zeit nach der Wechselfeldanregung der Probe, nach der das sich exponentiell vermindernde Signal auf 10 % seines Ausgangswertes abgefallen ist. Außerdem wurde die Signalamplitude $U_2$ in mV gemessen, die sich in einer Sekundärspule, die die Probe umgibt, mit einer Windungszahl von 100 Windungen einstellt zu einem Zeitpunkt, der 2 msec nach der Anregung der Probe lag.

Mit $H_{DC}$ in A/m ist das jeweils verwendete Gleichfeld zur Vormagnetisierung der Probe angegeben.

Tabelle 1

| Nr. | Zusammensetzung (at%) | $t_R$(ms) | $U_2$(mV) | $H_{DC}$(A/m) |
|---|---|---|---|---|
| 1 | Fe-78 Si-9 B-13 | 4.1 | 52 | 960 |
| 2 | Fe-65 Co-18 S-1 B-16 | 3.9 | 109 | 440 |
| 3 | Fe-41.5 Co-41.5 Si-1 B-16 | 8.5 | 141 | 520 |
| 4 | Fe-39.5 Co-41.5 Nb-1 Si-1 B-15 | 8.2 | 129 | 600 |
| 5 | Fe-39.5 Co-39.5 Si-6 B-15 | 7.8 | 153 | 440 |
| 6 | Fe-40 Ni-38 Mo-4 B-18 | 4.3 | 85 | 440 |
| 7 | Fe-40 Ni-38 Mo-4 B-18 | 5.2 | 93 | 160 |

In der Tabelle sind die mit den Nr. 1 und 2 gekennzeichneten Legierungen solche Legierungen, bei denen der Fe-Gehalt oberhalb der in der beanspruchten Formel angeführten Grenze liegt. Man sieht, daß sowohl die Abklingzeit $t_R$ als auch die Signalhöhe $U_2$ nach 2 msec weit unterhalb den Werten liegt, die bei den erfindungsgemäßen Beispiellegierungen 3, 4 und 5 gemessen werden.

Die Werte für die Legierung Nr. 6 wurden anhand von Proben bestimmt, die nach dem Gießen zu einem Band keine weitere Wärmebehandlung erfahren hatten. Die Legierung entspricht dem Stand der Technik; sie unterscheidet sich von den erfindungsgemäßen Legierungen durch eine deutlich kürzere Abklingzeit und eine geringere Signalamplitude. Die Werte der Legierung Nr. 7 sind an der gleichen Legierung, allerdings mit Wärmebehandlung gemessen worden. Man sieht, daS Abklingzeit und Signalspannung sich nur unwesentlich erhöhen, während ein wesentlich niedrigeres Gleichfeld erforderlich ist, um die optimalen Werte zu erzeugen.

Die Abhängigkeit der Meßwerte von der Anlaßbehandlung im Querfeld zeigt die nachstehende Tabelle 2 für die in der obigen Tabelle mit 3, 4 und 5 angegebenen Legierungen.

Tabelle 2

| Wärmebehandlung | | | | |
|---|---|---|---|---|
| Leg. Nr. | Zeit/Temp. | $t_R$(ms) | $U_2$(mV) | $H_{DC}$(A/m) |
| 3 | 3h 275°C | 7.0 | 128 | 560 |
| 3 | 3h 300°C | 6.6 | 144 | 640 |
| 3 | 3h 325°C | 8.5 | 141 | 520 |
| 3 | 1h 350°C | 7.5 | 148 | 520 |
| 4 | 3h 275°C | 6.1 | 110 | 680 |
| 4 | 3h 300°C | 7.2 | 124 | 640 |
| 4 | 3h 325°C | 8.2 | 129 | 600 |
| 4 | 1h 350°C | 6.4 | 143 | 640 |
| 5 | 3h 250°C | 5.5 | 134 | 440 |
| 5 | 3h 275°C | 7.5 | 149 | 480 |
| 5 | 3h 300°C | 6.7 | 157 | 480 |
| 5 | 1h 320°C | 7.8 | 153 | 440 |
| 5 | 3h 325°C | 6.3 | 165 | 440 |
| 5 | 3h 400°C | 7.4 | 149 | 460 |

Insbesondere bei den Legierungen 3 und 4 ergab sich, daß das amorphe Band nach der Anlaßbehandlung zusätzlich eine gute Duktilität besitzt, d. h. beim Schneiden oder bei Biegebeanspruchungen nicht bricht. Diese Eigenschaft ergibt sich insbesondere dann, wenn lange Wärmebehandlungszeiten bei relativ niedrigen Temperaturen vorgenommen werden und wenn der Anteil der Summe aus M, Si und B kleiner als 20 at% ist.

Vorteilhafterweise erzielt man bei einer Streifenlänge um 40 mm mit Verwendung der genannten beanspruchten Legierungen eine Resonanzfrequenz zwischen 55 kHz und 60 kHz bei einer Abklingzeit, die größer als 4 oder sogar 5 msec ist. Das Maximum der Signalamplitude entsteht dabei bei einem vormagnetisierten Gleichfeld im Bereich von 300 bis 800 A/m. Zur Erzeugung einer besonders hohen induzierten Anisotropie ist es vorteilhaft, wenn man eine Wärmebehandlung entweder im Querfeld oder unter Zugspannung des Materials durchführt. Es läßt sich auch gleichzeitig bei vorhandenem Querfeld und vorhandener Zugspannung die Wärmebehandlung vornehmen. Die erforderliche hohe Anisotropie senkrecht zur Bandlängsrichtung läßt sich aber auch durch eine partielle Kristallisation der Oberfläche erzeugen.

Neben den mechanischen und magnetischen Werten ist es für die vorliegende Erfindung vorteilhaft, wenn man besonders duktile Streifen verwenden kann, da sich diese ohne Bruch biegen lassen und dabei die magnetischen und mechanischen Eigenschaften nicht wesentlich beeinträchtigt werden. Besonders duktile Legierungen erreicht man, wenn man Legierungen der Formel nach Anspruch 1 verwendet, bei denen die Summe aus $x + y + z < 20$ at% gewählt ist.

## Patentansprüche

1. Verwendung einer amorphen, magnetostriktiven Legierung für Überwachungssysteme mit magnetoelastisch anregbaren Etiketten, **dadurch gekennzeichnet**, daß als Material für den magnetoelastisch anzuregenden Streifen eine Legierung eingesetzt wird, die der Formel

$$(Fe_{1-a-b}Co_aNi_b)_{100-x-y-z}M_xSi_yB_z$$

genügt, wobei M ein oder mehrere der Elemente der Gruppe IV bis VI des Periodensystems einschließlich C und P bedeutet und die Anteile folgenden Bedingungen genügen: a liegt zwischen 0.25 bis 0.9 b liegt zwischen 0 bis 5 x liegt zwischen 0 bis 5, y liegt zwischen 0 bis 12, z liegt zwischen 11 bis 20 mit der Maßgabe, daß die Summe $x + y > 0,5$, die Summe $a + b$ zwischen 0,25 bis 0,9 und die Summe $x + y + z$ zwischen 12 und 28 liegt.

2. Verwendung einer amorphen Legierung nach Anspruch 1, **dadurch gekennzeichnet**, daß die Legierung der Formel

$$(Fe_a Co_b )_x Si_y B_z$$

genügt, wobei 50 % des Fe oder des Co durch Ni ersetzt sein kann und a zwischen 0.1 und 0.7, b zwischen 0.3 bis 0.9, $a + b = 1$, x zwischen 70 bis 85 at%, y zwischen 1 bis 8 at% und z zwischen 11 at% und 20 at% liegt.

3. Verwendung einer amorphen Legierung nach Anspruch 1, **dadurch gekennzeichnet**, daß die Legierung etwa 30 bis 40 at% Eisen, 39 bis 49 at% Kobalt, 4 bis 6 at% Silizium, 4 bis 17 at% Bor und 0 - 5 at% Niob oder Molybdän enthält.

4. Verwendung einer amorphen Legierung nach Anspruch 1, **dadurch gekennzeichnet**, daß bei einer Streifenlänge im Bereich von 30 bis 50 mm die Resonanzfrequenz zwischen 55 kHz und 60 kHz liegt und daß gleichzeitig die Abklingzeit, in der das Signal auf 10 % des Ausgangswertes abfällt, größer als 4 msec ist.

5. Verwendung einer amorphen Legierung nach Anspruch 4, **dadurch gekennzeichnet**, daß die Abklingzeit > 5 msec ist.

6. Verwendung einer amorphen Legierung nach Anspruch 1, **dadurch gekennzeichnet**, daß das Maximum der Signalamplitude bei einem vormagnetisierten Gleichfeld der Stärke 300 bis 800 A/m auftritt.

7. Verwendung einer amorphen Legierung nach Anspruch 1, **dadurch gekennzeichnet**, daß zur Erzielung der Resonanzeigenschaften eine Wärmebehandlung im Querfeld stattfindet.

8. Verwendung einer amorphen Legierung nach Anspruch 1, **dadurch gekennzeichnet**, daß zur Erzielung der Resonanzeigenschaften eine Wärmebehandlung bei Zugspannung in Längsrichtung stattfindet.

9. Verwendung einer amorphen Legierung nach Anspruch 1, **dadurch gekennzeichnet**, daß die Resonanzeigenschaft durch eine partielle Kristallisation der Oberfläche erfolgt.

10. Verwendung einer amorphen Legierung nach Anspruch 1, **<u>dadurch gekennzeichnet</u>**, daß für die Anteile der Legierungselemente folgende Beziehungen gelten: a 0.4 bis 0.6 b 0 bis 0.2 und die Summe a + b zwischen 0.4 und 0.6.

11. Verwendung einer amorphen Legierung nach Anspruch 1, **<u>dadurch gekennzeichnet</u>**, daß zur Erzeugung besonders duktiler Streifen die Summe aus den Anteilen x + y + z < 20 at% ist.

Europäisches
Patentamt

**EUROPÄISCHER RECHERCHENBERICHT**

Nummer der Anmeldung

EP 95 11 0876

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.CL6) |
|---|---|---|---|
| X | WO-A-93 09549 (ALLIED SIGNAL INC) 13.Mai 1993<br>* Ansprüche 1 und 8; Beispiel 9 *<br>--- | 1,2,4, 6-11 | C22C45/04<br>H01F1/153<br>H01L41/20<br>G08B13/24 |
| X | CN-A-1 051 265 (SHANGHAI INST. IRON) 8.Mai 1991<br>* Zusammenfassung; Ansprüche 2 und 4 *<br>--- | 1,2 | |
| X | EP-A-0 253 580 (UNITIKA LTD) 20.Januar 1988<br>* Seite 4, Zeilen 5-13 *<br>--- | 1 | |
| A | EP-A-0 295 028 (SCIENT GENERICS LTD) 14.Dezember 1988<br>* Zusammenfassung; Anspruch 27; Seite 2, Zeilen 1-3 *<br>--- | 1-11 | |
| A | GB-A-2 233 346 (PITNEY BOWES) 9.Januar 1991<br>* Zusammenfassung; Ansprüche 1,4,11 *<br>--- | 1-11 | RECHERCHIERTE SACHGEBIETE (Int.Cl.6) |
| A,D | WO-A-90 03652 (ALLIED SIGNAL INC) 5.April 1990<br>----- | 1-11 | C22C<br>H01F<br>H01L<br>G08B |

Der vorliegende Recherchenbericht wurde für alle Patentansprüche erstellt

| Recherchenort | Abschlußdatum der Recherche | Prüfer |
|---|---|---|
| MÜNCHEN | 19.Dezember 1995 | Pivalica-Bjoerk, P |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
.........................................................................
& : Mitglied der gleichen Patentfamilie, übereinstimmendes Dokument